# FASCICULE DE BREVET EUROPEEN

(11) **EP 2 260 576 B1**
(45) Date de publication et mention de la délivrance du brevet: **07.12.2011**
(21) Numéro de dépôt: 09727451.8
(22) Date de dépôt: 26.03.2009
(51) Int. Cl.: H03M 1/20, H03M 1/06

(54) **CONVERTISSEUR ANALOGIQUE-NUMERIQUE RAPIDE A STRUCTURE DE REPLIEMENT DE SIGNAL AMELIOREE PAR REDUCTION DU NOMBRE DE CELLULES ELEMENTAIRES**
HOCHGESCHWINDIGKEITS-ANALOG-DIGITAL-WANDLER MIT VERBESSERTER ANTIALIASING-SIGNALSTRUKTUR DURCH REDUZIERUNG DER ANZAHL AN ELEMENTARZELLEN
HIGH-SPEED ANALOGUE-DIGITAL CONVERTER HAVING A SIGNAL ANTI-ALIASING STRUCTURE IMPROVED BY REDUCING THE NUMBER OF ELEMENTARY CELLS

(30) Priorité: 04.04.2008 FR 0801872
(43) Date de publication de la demande: 15.12.2010
(73) Titulaire: E2V Semiconductors, 38120 Saint Egrève (FR)
(72) Inventeur: BRUEL, Sandrine, F-38000 Grenoble (FR); BORE, François, F-38420 Revel (FR)
(74) Mandataire: Guérin, Michel
(86) Numéro de dépôt international: PCT/EP2009/053570
(87) Numéro de publication internationale: WO 2009/121783

(56) Documents cités:
- FR-A- 2 887 708
- US-A1- 2001 040 522
- HIDRI O ET AL: "A 1.8-V 1.6-GSample/s 8-b Self-Calibrating Folding ADC With 7.26 ENOB at Nyquist Frequency" IEEE JOURNAL OF SOLID-STATE CIRCUITS, IEEE SERVICE CENTER, PISCATAWAY, NJ, US, vol. 39, no. 12, 1 décembre 2004 (2004-12-01), pages 2107-2115, XP011122649 ISSN: 0018-9200

## Description

L'invention concerne les convertisseurs analogiques-numériques de haute résolution utilisant des structures d'amplificateurs différentiels dites à repliement.

Le principe des structures de repliement de signal est le suivant : le signal analogique d'entrée à convertir est appliqué à l'entrée d'un groupe d'amplificateurs différentiels recevant des tensions de référence régulièrement réparties ; ces amplificateurs fournissent des signaux dits "repliés" ayant une amplitude qui varie à peu près sinusoïdalement avec l'amplitude du signal d'entrée, avec une période qui est définie par l'écartement des tensions de référence distribuées dans une gamme utile d'amplitudes à convertir. Le nombre de tensions de référence dans un groupe définit le nombre de périodes de la courbe de signal replié dans cette gamme utile. Les bits de la conversion analogique-numérique pour une valeur de tension d'entrée sont définis par l'appartenance du signal issu de la structure de repliement à un des intervalles définis par les passages par zéro de la courbe de signal replié.

Les tensions de référence sont produites par un ou plusieurs ponts de résistances alimentés par un courant de référence constant ou alimenté entre deux tensions de référence. Les structures de précision destinées à la conversion de haute résolution sont le plus souvent différentielles et on décrira ci-après le cas de structures différentielles.

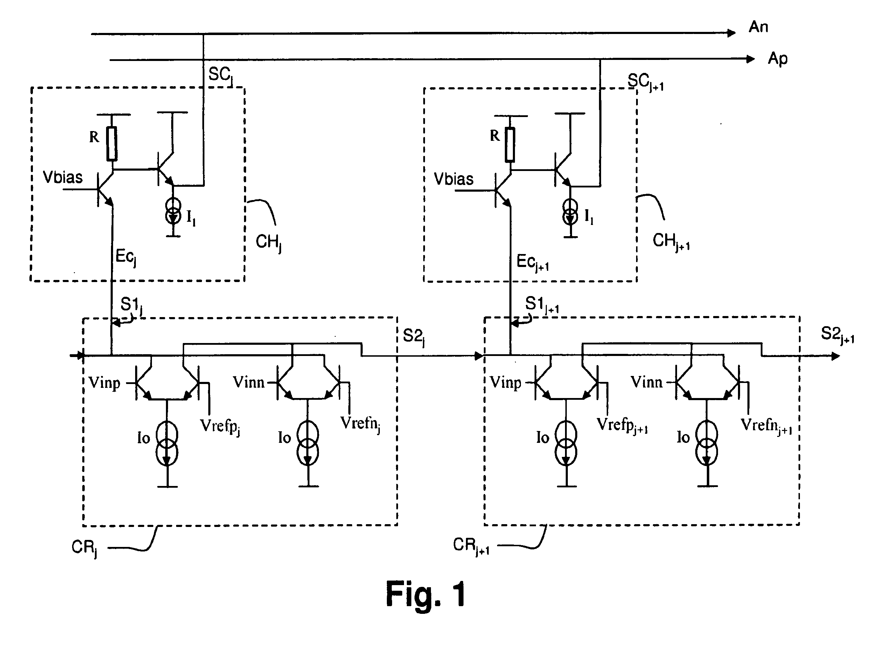

La figure 1 représente la constitution de base d'une structure de repliement de signal. Elle comprend deux circuits différentiels élémentaires constitués chacune par une double paire différentielle de transistors qui établissent des courants fonction de la différence entre la tension à convertir et des tensions de référence, et deux circuits de charge qui convertissent en tension ces courants. Un bloc de repliement de signal comprend plusieurs groupes de deux circuits différentiels et les circuits de charge associés. Une structure de repliement peut comprendre plusieurs blocs de repliement. Le nombre de circuits dans un bloc détermine le nombre de périodes de repliement de la courbe de repliement engendrée par ce bloc. Le nombre de blocs détermine le nombre de courbes de repliement parallèles engendrées simultanément. Les courbes de repliement sont régulièrement espacées les unes des autres et leurs passages par zéro sont précisément définis par rapport aux références de tension fournies par les ponts de résistances.

Les circuits différentiels comportent chacun quatre entrées (deux paires d'entrées différentielles) et deux sorties ; les sorties de circuits adjacents sont reliées les unes aux autres d'une manière qu'on détaillera plus loin. On peut considérer que les circuits de charge comportent chacun une entrée et une sortie ; l'entrée est reliée à une sortie de circuit différentiel ; la sortie est reliée à un conducteur de sortie du bloc de repliement.

Comme on le verra, il y a dans un même bloc de repliement des circuits de charge de rang impair dont l'entrée est connectée à une première sortie d'un circuit différentiel (et connectée en même temps à une deuxième sortie d'un circuit différentiel immédiatement précédent dans la série) et des circuits de charge de rang pair dont l'entrée est connectée à une deuxième sortie du circuit différentiel (et connectée en même temps à une première sortie d'un circuit différentiel immédiatement suivant). Toutes les sorties de circuits de charge de rang impair sont connectées à un premier conducteur de sortie du bloc de repliement, et toutes les sorties de circuits de charge de rang pair sont connectées à un deuxième conducteur de sortie du bloc.

La figure 1 représente un exemple de constitution d'un groupe de deux circuits différentiels adjacents CRⱼ et CRⱼ₊₁ et de deux circuits de charge correspondants CHⱼ et CHⱼ₊₁ connectés comme indiqué ci-dessus et destinés à être reliés à d'autres circuits différentiels dans un même bloc de repliement. L'indice j représente le rang des circuits consécutifs dans la série constituant un bloc.

Un circuit différentiel tel que CRj comprend deux paires différentielles de transistors ; chaque paire est alimentée par une source de courant constant I₀. Le courant est le même pour les deux paires et pour tous les circuits différentiels. Les transistors d'une paire sont reliés par leurs émetteurs à cette source de courant. Dans la suite on considérera que les transistors sont des transistors bipolaires, l'invention étant utilisable avec des transistors MOS également.

Le circuit CRj possède quatre entrées qui sont les bases des quatre transistors constituant les deux paires. La première paire reçoit respectivement une tension de signal à convertir Vinp et une tension de référence Vrefpⱼ. La deuxième paire reçoit respectivement une tension de signal à convertir Vinn et une tension de référence Vrefnⱼ. Le groupe de tensions Vinp, Vinn constitue la tension d'entrée différentielle à convertir, à comparer avec des tensions différentielles de référence définies par les tensions Vrefpⱼ, Vrefnⱼ.

Les mêmes tensions Vinp et Vinn sont appliquées aux transistors correspondants de tous les circuits différentiels. Elles peuvent provenir d'un échantillonneur-bloqueur ou d'un simple amplificateur différentiel. Les tensions de référence sont différentes pour les différents circuits différentiels : ce sont des tensions Vrefpⱼ₊₁ et Vrefnⱼ₊₁ pour le circuit CRⱼ₊₁ de rang j+1. Les tensions de référence pour les différents circuits différentiels sont régulièrement réparties entre une valeur basse et une valeur haute et elles proviennent des prises intermédiaires d'un pont de résistances non représenté.

Le collecteur du transistor qui reçoit la tension d'entrée dans une paire différentielle est relié au collecteur du transistor qui reçoit une tension de référence sur l'autre paire. Les collecteurs ainsi réunis par couple de deux constituent deux sorties S1ⱼ et S2ⱼ du circuit différentiel CRⱼ.

Ces sorties S1ⱼ et S2ⱼ servent d'une part à la connexion entre les circuits différentiels consécutifs et d'autre part à la connexion aux circuits de charge.

La première sortie S1ⱼ du circuit différentiel de rang j est connectée à la deuxième sortie (non représentée) du circuit différentiel immédiatement précédent, de rang j-1 (s'il existe). Réciproquement, la deuxième sortie S2j du circuit différentiel de rang j est reliée à la première sortie du circuit différentiel de rang immédiatement suivant j+1 (s'il existe).

Le circuit de charge de rang j (CHⱼ) a son entrée Ecⱼ reliée à la première sortie S1ⱼ du circuit différentiel CRⱼ de même rang.

Il en résulte que chaque circuit de charge est partagé entre deux circuits différentiels adjacents puisqu'un circuit de charge est connecté à la fois à la première sortie du circuit de rang j et à la deuxième sortie du circuit de rang j-1.

La sortie Scⱼ du circuit de charge de rang j est reliée à un conducteur de sortie Ap, mais la sortie du circuit de charge de rang immédiatement suivant est reliée à un autre conducteur de sortie An. Ces deux conducteurs sont communs à tout le bloc de repliement et constituent les deux sorties (fournissant un signal replié) du bloc. Les sorties des circuits de charge de la succession sont alternativement connectés au conducteur An et au conducteur Ap. Par exemple, tous les circuits de charge de rang impair ont leur sortie reliée au conducteur Ap et tous les circuits de charge de rang pair ont leur sortie reliée au conducteur An.

Les circuits de charge sont par ailleurs tous identiques ; le circuit de charge de rang j est, dans cet exemple, constitué à partir de deux transistors qui sont respectivement un transistor cascode et un transistor suiveur ; le transistor cascode a son émetteur relié à l'entrée Ecⱼ, sa base reliée à un potentiel de polarisation fixe commun à tout le bloc de repliement, et son collecteur relié par une résistance (identique pour tous les circuits) alimentée par une tension d'alimentation ; le transistor suiveur a sa base reliée au collecteur du transistor cascode, son émetteur relié à une source de courant constant de valeur I₁, et son collecteur relié à une tension d'alimentation. La sortie Scⱼ du circuit de charge est prise sur l'émetteur du transistor suiveur. Le transistor cascode sert à éviter que la tension sur les sorties du circuit différentiel varie trop en fonction du niveau de signal d'entrée Vinp, Vinn.

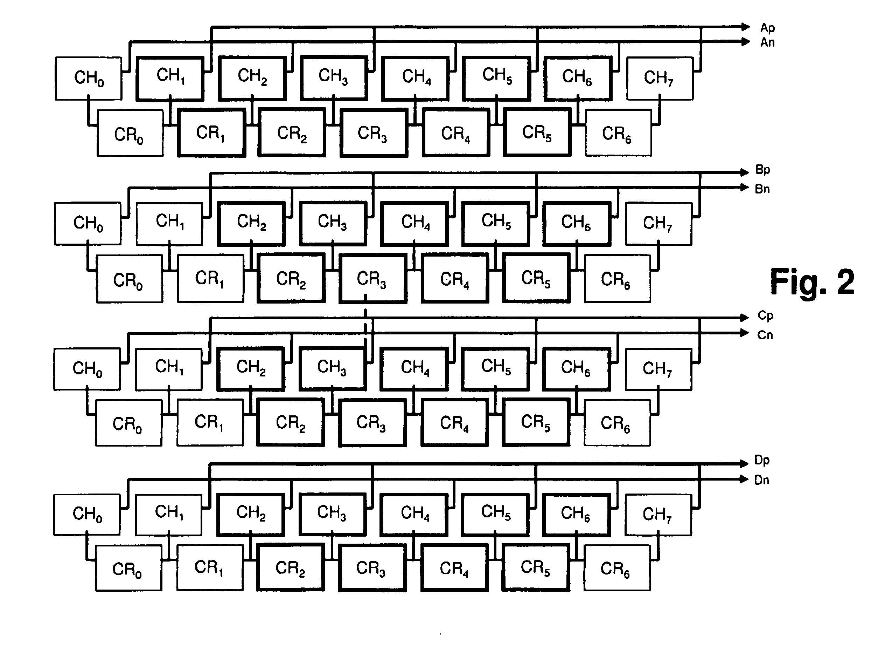

La figure 2 représente l'organisation générale d'une structure de repliement à plusieurs blocs comportant chacun plusieurs circuits différentiels et les charges associées. L'exemple est donné pour une structure qui engendre quatre courbes de repliement (et qui comporte à cet effet quatre blocs représentés l'un au-dessous de l'autre), chaque courbe de repliement comportant deux périodes complètes dans une gamme utile de tensions analogiques à convertir.

Pour engendrer quatre courbes différentes, les blocs reçoivent des tensions différentes provenant soit d'un pont de résistances respectif pour chaque bloc soit d'un pont commun pour tous les blocs, les prises successives le long du pont servant successivement aux différents blocs. Le ou les ponts de résistances ne sont pas représentés pour ne pas alourdir le schéma.

Chaque bloc comporte un couple de sorties : Ap, An pour le premier bloc, Bp, Bn pour le deuxième bloc, et Cp, Cn, Dp, Dn pour lés deux derniers.

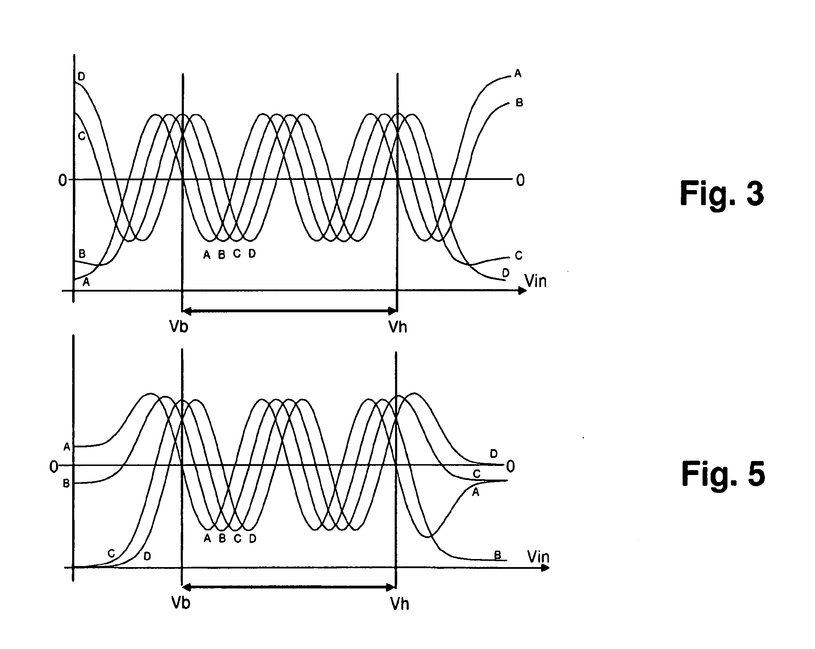

Ces sorties fournissent des signaux repliés visibles à la figure 3 : signal de sortie replié en fonction de la tension d'entrée. Chaque bloc fournit une courbe repliée respective A, B, C, D. La courbe A est une représentation de la tension obtenue entre les conducteurs de sortie Ap et An du premier bloc. Les courbes B, C, D représentent les tensions de sortie des autres blocs. Les bloc de repliement sont utilisables dans une gamme d'entrée entre une tension basse Vb et une tension haute Vh. Dans cette gamme les courbes repliées d'allure sinusoïdale sont véritablement régulières et leurs croisements sont régulièrement espacées. En dehors de cette gamme, les courbes sont déformées par des effets de bord liés au fait que les charges des circuits différentiels des extrémités du bloc ne sont pas partagées entre deux circuits différentiels.

Le nombre de circuits différentiels nécessaires dans chaque bloc pour engendrer deux périodes de repliement dans la gamme utile Vb, Vh est de quatre. En effet, à chaque circuit différentiel correspond un passage par zéro de la courbe de repliement et il faut quatre passages par zéro pour compléter les deux périodes. Toutefois, le premier bloc de repliement comporte cinq circuits différentiels et non quatre car la courbe de repliement A comporte au total cinq passages par zéro si on inclut le passage par zéro à Vb et le passage par zéro à Vh ; ces passages à zéro pour Vb et Vh sont nécessaires pour définir les valeurs limites Vb, Vh, de la gamme utile.

Par conséquent, si on reprend le schéma de la figure 2, on peut considérer que les circuits nécessaires à l'élaboration des quatre courbes de repliement A, B, C, D à deux périodes complètes chacune sont :
- les circuits différentiels CR1 à CR5 et les circuits de charge correspondants CH1 à CH6 pour le premier bloc
- des circuits différentiels CR2 à CR5 et des circuits de charge correspondants CH2 à CH6 pour chacun des autres blocs.

Pour assurer au mieux la régularité des courbes aux alentours des limites de la gamme utile en vue d'un traitement analogique en aval, on prévoit en outre au moins un circuit différentiel supplémentaire de chaque côté et un circuit de charge associé. Pour le premier bloc (courbe A), ces circuits supplémentaires sont les circuits différentiels CR₀ et CR₆ et les circuits de charge associés CH₀ et CH₇. Pour les autres blocs, les circuits supplémentaires sont les circuits CR₁ et CR₆ et les circuits de charge associés CH₁ et CH₇. Enfin, pour assurer une symétrie globale de l'ensemble de la structure (et notamment une symétrie et une homogénéité des charges), on fait en sorte qu'il y ait le même nombre de circuits différentiels et de charges dans tous les blocs, ce qui implique d'autres circuits supplémentaires CR₀ et CH₀ pour les trois blocs fournissant les courbes B, C, D. Ceci permet que toutes les courbes A,B,C,D aient exactement la même amplitude et des passages par zéro régulièrement espacés.

Par conséquent, dans la structure de la figure 2, les circuits différentiels et circuits de charge définissant les courbes de repliement de la gamme utile sont les circuits représentés en traits plus gras sur la figure, et les circuits supplémentaires, qui servent seulement à mieux ajuster ces courbes, sont représentés en traits fins.

On comprend que le nombre de circuits supplémentaires est important, et engendre une consommation de courant élevée et un encombrement élevé sur le circuit intégré. En effet, dans l'exemple donné, il y a 17 circuits différentiels et 21 circuits de charge établissant les fonctions de repliement désirées et 11 circuits différentiels et 11 circuits de charge supplémentaires pour améliorer ces courbes.

L'invention vise à réduire le nombre de ces circuits supplémentaires dans les convertisseurs analogique-numérique à structures de repliement.

A cet effet, l'invention propose un convertisseur analogique-numérique à circuits de repliement de signal, comportant au moins deux blocs de repliement, chaque bloc comportant une série de N+1 circuits différentiels de rang 1 à N+1, avec N entier, et une série de N+2 circuits de charge de rang 1 à N+2 associés aux circuits différentiels de chaque série, les circuits différentiels de chaque bloc étant juxtaposés et reliés les uns aux autres par leurs sorties, chaque circuit différentiel ayant quatre entrées et deux sorties, la première sortie d'un circuit différentiel de rang j étant reliée à la deuxième sortie d'un circuit différentiel précédent de rang j-1 de la série et la deuxième sortie du circuit différentiel considéré étant reliée à la première sortie du circuit différentiel suivant de rang j+1, un premier circuit de charge de rang j étant relié à la première sortie du circuit différentiel considéré de rang j, ce circuit de charge étant partagé avec le circuit différentiel précédent de rang j-1 de la série, et un deuxième circuit de charge de rang j+1 étant relié à la deuxième sortie du circuit différentiel considéré de rang j, ce circuit de charge étant partagé avec le circuit différentiel suivant de rang j+1 de la série, les circuits de charge de rang pair ayant une sortie connectée à une première sortie commune de la série et les circuits de charge de rang impair ayant une sortie connectée à une deuxième sortie commune de la série, caractérisé en ce qu'il est prévu pour tous les blocs un circuit différentiel supplémentaire de rang N+2 et un circuit de charge supplémentaire de rang N+3 connecté à la deuxième sortie du circuit différentiel supplémentaire, la sortie de ce dernier circuit de charge n'étant pas reliée à une sortie commune de la série, et en ce qu'il est prévu en outre, dans le premier bloc de repliement, un circuit différentiel de rang 0 et un circuit de charge de rang 0 connecté à la première sortie du circuit différentiel de rang 0, la sortie du circuit de charge de rang 0 n'étant pas reliée à une sortie commune du premier bloc.

Bien qu'on détériore légèrement l'erreur de non-linéarité intégrale engendrée par cette structure, on réduit significativement le nombre de circuits différentiels élémentaires et le nombre de circuits de charge associés, de sorte qu'on gagne beaucoup en consommation et encombrement, ainsi qu'en vitesse de fonctionnement du convertisseur.

Le nombre de périodes des courbes repliées dans la gamme utile de tensions à convertir est N/2.

Les circuits de charge sont de préférence constitués par un transistor cascode et un transistor suiveur. Les circuits de charge n'ayant pas de sortie reliée à une sortie du bloc n'ont cependant pas besoin d'avoir un transistor suiveur.

Les circuits différentiels sont de préférence constitués par une double paire différentielle de transistors, un transistor d'une paire ayant son collecteur relié au collecteur d'un transistor de l'autre paire et réciproquement. En pratique, le collecteur d'un transistor d'une paire qui reçoit sur sa base une tension à convertir est relié au collecteur d'un transistor de l'autre paire qui reçoit sur sa base une tension de référence, et de même pour les deux autres transistors.

Les publications de brevet FR2887708 et US 2001/0040522, ainsi que l'article de Hidri et Al "A 1.8-V 1.6-GSample/s 8-b Self-Calibrating Folding ADC With 7.26 ENOB at Nyquist Frequency" dans IIEEE J of Solid-State Circuits Vol 39 N°12n 1er déc 2004 pages 2107-2115 XP011122649, décrivent des convertisseurs analogiques-numériques à repliement.

D'autres caractéristiques et avantages de l'invention apparaîtront à la lecture de la description détaillée qui suit et qui est faite en référence aux dessins annexés dans lesquels :
- la figure 1 représente un exemple de structure de repliement de signal ;
- la figure 2 représente la constitution générale d'une structure de l'art antérieur dans le cas où on veut quatre courbes repliées à deux périodes de repliement dans la gamme utile de tensions d'entrée ;
- la figure 3 représente les courbes de repliement de la structure de la figure 2 ;
- la figure 4 représente la constitution générale d'une structure de repliement selon l'invention ;
- la figure 5 représente les courbes de repliement associées ;

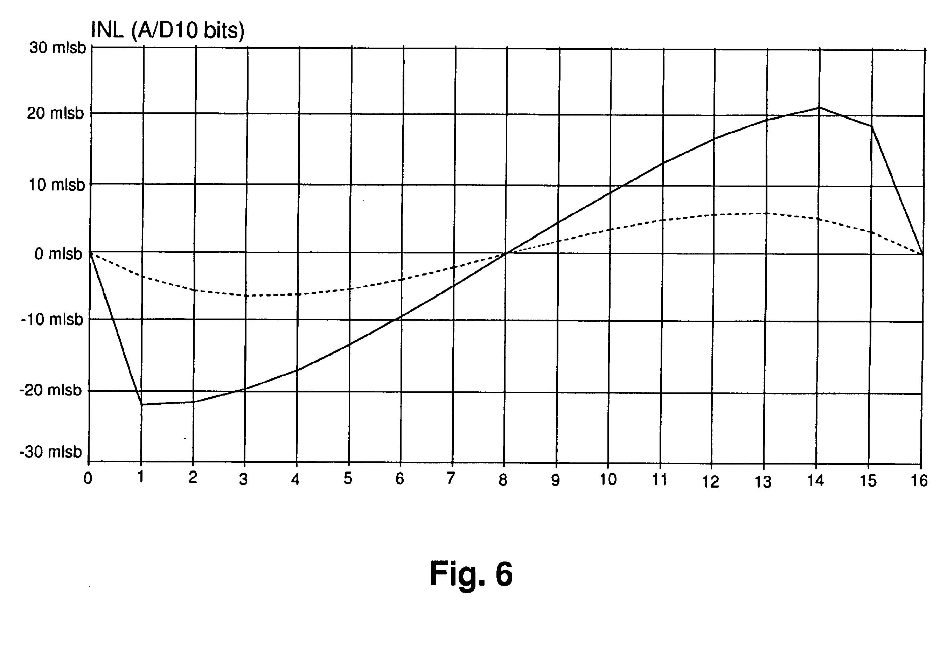

- la figure 6 représente une courbe de non-linéarité intégrale de la structure selon l'invention dans le cas d'un convertisseur analogique-numérique utilisant la structure de la figure 4.

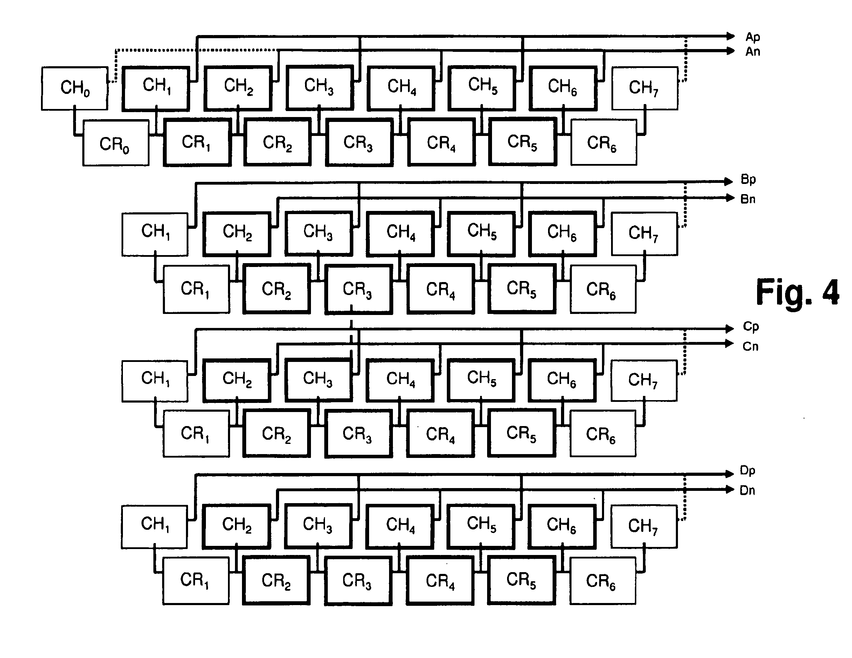

La figure 4 sera comparée à la figure 3. Elle correspond comme la figure 3 à une structure de repliement à quatre blocs de repliement placés les uns aux dessus des autres sur la figure. Chaque bloc possède deux sorties (pour une structure différentielle) qui sont An et Ap pour le premier bloc, Bn et Bp pour le deuxième, Cn et Cp pour le troisième, et Dn et Dp pour le quatrième.

Les blocs de repliement comportent chacun une série de circuits différentiels et une série de circuits de charge. Les circuits différentiels sont désignés par les références CRⱼ, l'indice j correspondant au rang du circuit différentiel dans la série. Les circuits de charge sont désignés par les références CHⱼ, l'indice j correspondant également au rang du circuit de charge dans la série.

Les circuits différentiels et les circuits de charges peuvent être conformes à ceux de la figure 1 et on ne les redécrira pas : un circuit différentiel comporte en résumé une double paire différentielle de transistors, quatre entrées et deux sorties. La première sortie d'un circuit différentiel CRⱼ de rang j est reliée à une entrée d'un circuit de charge CHⱼ de rang j et à la deuxième sortie du circuit différentiel CRⱼ₋₁ de rang j-1. La deuxième sortie d'un circuit différentiel CRⱼ est reliée à une entrée d'un circuit de charge CHⱼ₊₁ d'un circuit différentiel de rang j+1 et à une entrée d'un circuit de charge de rang j+1. Les sorties de tous les circuits de charge de rang impair sont reliées à une première sortie du bloc de repliement (par exemple la sortie Ap pour le premier bloc) et les sorties de tous les circuits de charge de rang pair sont reliées à une deuxième sortie (par exemple la sortie An pour le premier bloc) du bloc de repliement. Les circuits de charge peuvent être des étages cascode ayant une entrée en courant sur un émetteur de transistor (à polarisation de base fixe) et une sortie en tension sur l'émetteur d'un autre transistor qui est un transistor suiveur.

Il y a dans chaque bloc de repliement au moins N circuits différentiels servant à produire les repliements nécessaires pour que la courbe de repliement passe N fois par zéro dans une gamme utile de tensions d'entrée Vin à convertir. N est un entier, pair dans le cas général où le nombre de périodes de la courbe replie sinusoïdale est entier. On rappelle que dans une structure différentielle, la tension Vin possède deux valeurs qui sont une valeur positive Vinp et une valeur négative Vinn, mais pour simplifier les explications on considérera une seule valeur Vin représentant la différence Vinp-Vinn. Dans la conversion analogique-numérique, on cherche à définir une valeur numérique de Vin en comparant cette valeur à des valeurs de référence Vrefⱼ qui sont elles-mêmes différentielles et qui sont donc des différences Vrefpⱼ-Vrefnⱼ.

Dans l'exemple de la figure 4, on cherche à produire 2 périodes complètes de courbe de repliement dans la gamme utile Vb, Vh, et il faut donc au moins N=4 circuits différentiels pour chacun des blocs. Cependant on veut que l'une des courbes passe par zéro à la fois pour la valeur Vb et la valeur Vh, ce qui requiert en fait N+1 circuits différentiels pour la première courbe.

Ces circuits différentiels strictement nécessaires à la production des N passages par zéro sont représentés en gras sur la figure 4. Ce sont les circuits CR₁ à CR₅ (rang 1 à N+1) pour le premier bloc, et les circuits CR₂ à CR₅ (rangs 1 à N) pour les trois autres blocs.

Mais pour des raisons de symétrie, on prévoit aussi N+1 passages par zéro pour ces trois autres blocs. Il y a donc un circuit différentiel CR₁ de rang 1 supplémentaire pour chacun des trois autres blocs.

Les charges associées aux N+1 circuits différentiels ainsi décrits dans chaque bloc sont désignées par le même rang, mais pour N+1 circuits différentiels il y a N+2 circuits de charge puisqu'une charge est connectée à chacune des deux sorties d'un circuit différentiel. Les charges associées aux circuits différentiels strictement nécessaires sont en gras sur la figure 4. Ce sont les charges CH₁ à CH₆ pour le premier bloc, et les charges CH₂ à CH₆ pour chacun des trois autres. Les charges associées aux circuits différentiels supplémentaires mentionnés précédemment sont des charges CH₁ représentées en traits fins.

Selon l'invention, outre les circuits différentiels et les charges associées qui viennent d'être précisées, on prévoit des circuits différentiels supplémentaires connectés différemment des autres :
- tous les blocs possèdent un circuit différentiel supplémentaire de rang N+2 et un circuit de charge supplémentaire connecté à la deuxième sortie du circuit différentiel supplémentaire, mais ce circuit de charge supplémentaire de rang N+3 n'a pas de sortie reliée à un conducteur de sortie du bloc ; sur la figure, c'est le circuit CR₆ et la charge CH₇;
- le premier bloc de repliement possède un circuit différentiel CR₀ de rang 0 et un circuit de charge de rang 0 connecté à la première sortie du circuit différentiel de rang 0, mais ce circuit de charge n'a pas de sortie reliée à un conducteur de sortie du bloc.

Les circuits de charge supplémentaires de rang 0 et de rang N+3 consomment donc du courant issu des sorties des circuits différentiels de rang 0 et de rang N+2, mais ils ne contribuent pas directement au signal de sortie présent sur les conducteurs de sortie du bloc.

Pour cette raison, les circuits de charge supplémentaires de rang 0 et N+3 ne sont pas nécessairement identiques aux circuits de charge de rang 1 à N+2. Par exemple, dans le cas de la figure 1 où le circuit de charge comporte un transistor cascode et un transistor suiveur relié au conducteur de sortie, on peut supprimer purement et simplement le transistor suiveur dans les circuits de charge de rang 0 et N+3. Les circuits différentiels supplémentaires de rang 0 et N+2 sont tous identiques aux circuits différentiels de rang 1 à N+1.

La figure 5 représente les courbes de repliement qui résultent de la structure de la figure 4. On voit que ces courbes ne sont pas tout-à-fait identiques aux courbes de la figure 3. On peut même dire qu'elles produisent des passages par zéro moins régulièrement réparties que celles de la figure 3. Mais l'erreur de non-linéarité supplémentaire engendrée par cette disposition est très faible par rapport aux autres erreurs qu'on peut rencontrer dans un convertisseur analogique-numérique, et en particulier les erreurs dues aux imprécisions technologiques, par exemple sur les valeurs de résistances des ponts de résistances qui définissent les passages par zéro des courbes de repliement, ou sur les valeurs de tension de décalage (offset) des paires différentielles.

Typiquement, on a fait les simulations suivantes dans un exemple concret de convertisseur de résolution 10 bits : les erreurs de variations technologiques engendrent une imprécision de l'ordre de 1,2 LSB (LSB = bit le moins significatif) crête à crête ; l'erreur de non-linéarité intégrale (INL) due intrinsèquement à la structure de la figure 2 ne dépasse pas 0,025 LSB crête à crête ; l'erreur de non-linéarité intégrale liée à la structure de la figure 4 dans les mêmes conditions (notamment de valeurs de courants consommés par les entrées des amplificateurs différentiels et de valeur de courant dans le pont de résistances) s'est avérée supérieure à celle de la figure 2 mais n'a pas dépassé 0,050 LSB, ce qui est complètement négligeable devant les erreurs due à l'imprécision technologique.

La figure 5 représente la courbe de non linéarité intégrale mesurée pour la figure 2 (traits tiretés) et pour la figure 4 (traits pleins). En abscisse on a les 16 points de passage par zéro des quatre courbes de repliement dans la gamme utile entre Vb et Vh. En ordonnée, graduée en millièmes de LSB normalisés pour une résolution de 10 bits, on a l'erreur systématique engendrée par la structure choisie pour faire le repliement.

Mais malgré cette augmentation de l'erreur de non-linéarité intégrale, la structure de la figure 4 est beaucoup plus avantageuse que celle de la figure 2, en termes de nombres de circuits différentiels et de circuits de charge associés. On y gagne en encombrement, consommation de courant et vitesse.

La structure de la figure 2 utilise, pour quatre courbes de repliement à deux périodes de repliement chacune dans la gamme utile, 28 circuits différentiels et 32 circuits de charge associés. La structure de la figure 4 utilise 25 circuits différentiels et 29 circuits de charge associés. Sur ces 29 circuits de charge, seulement 25 consomment du courant sur les conducteurs de sortie des blocs de repliement. On gagne environ 10% sur l'encombrement et la dissipation, et 25% sur la charge des sorties des blocs de repliement.

Pour une structure à 8 blocs de repliement et deux périodes de sinusoïde par courbe, on passerait de 56 circuits différentiels et 64 circuits de charge à 49 circuits différentiels et 57 circuits de charge.

Le gain est moins important mais significatif quand même pour une structure fournissant des courbes de repliement à quatre périodes de sinusoïde dans la gamme utile.

La structure différentielle selon l'invention peut servir tout particulièrement comme l'étage d'entrée d'un convertisseur analogique-numérique, cet étage recevant directement la tension à convertir Vinn, Vinp, d'un échantillonneur bloqueur différentiel. Cet étage d'entrée de convertisseur peut être suivi d'une structure d'interpolation produisant, à partir des sorties du premier étage, des courbes repliées intermédiaires entre les courbes obtenues dans le premier étage. Un autre étage de repliement peut être prévu en aval de cette structure d'interpolation.

L'invention est particulièrement intéressante pour les convertisseurs de moyenne résolution (entre 6 et 12 bits).

## Revendications

1. Convertisseur analogique-numérique à circuits de repliement de signal, comportant au moins deux blocs de repliement, chaque bloc comportant une série de N+1 circuits (CRⱼ) différentiels de rang 1 à N+1, avec N entier, et une série de N+2 circuits de charge (CHⱼ)de rang 1 à N+2 connectés aux circuits différentiels de la série de circuits différentiels, les circuits différentiels de chaque bloc étant juxtaposés et reliés les uns aux autres par leurs sorties (S2ⱼ, S1ⱼ₊₁), chaque circuit différentiel ayant quatre entrées et deux sorties, la première sortie (S1ⱼ) d'un circuit différentiel de rang j étant reliée à la deuxième sortie d'un circuit différentiel précédent de rang j-1 de la série et la deuxième sortie (S2ⱼ) du circuit différentiel considéré étant reliée à la première sortie du circuit différentiel suivant de rang j+1, un premier circuit de charge (CHⱼ) de rang j étant relié à la première sortie du circuit différentiel (CRⱼ) considéré de rang j, ce circuit de charge étant partagé avec le circuit différentiel précédent de rang j-1 de la série, et un deuxième circuit de charge de rang j+1 étant relié à la deuxième sortie du circuit différentiel considéré de rang j, ce circuit de charge étant partagé avec le circuit différentiel suivant de rang j+1 de la série, les circuits de charge de rang pair ayant une sortie connectée à une première sortie commune (An) de la série et les circuits de charge de rang impair ayant une sortie connectée à une deuxième sortie commune (Ap) de la série, **caractérisé en ce qu'**il est prévu pour tous les blocs un circuit différentiel supplémentaire (CR₆) de rang N+2 et un circuit de charge supplémentaire (CH₇) de rang N+3 connecté à la deuxième sortie du circuit différentiel supplémentaire, la sortie de ce dernier circuit de charge n'étant pas reliée à une sortie commune de la série, et **en ce qu'**il est prévu en outre, dans le premier bloc de repliement, un circuit différentiel (CR₀) de rang 0 et un circuit de charge (CH₀) de rang 0 connecté à la première sortie du circuit différentiel de rang 0, la sortie du circuit de charge de rang 0 n'étant pas reliée à une sortie commune du premier bloc.

2. Convertisseur selon la revendication 1, **caractérisé en ce que** les circuits différentiels sont constitués par une double paire différentielle de transistors, un transistor d'une paire ayant son collecteur relié au collecteur d'un transistor de l'autre paire et réciproquement.

3. Convertisseur selon l'une des revendications 1 et 2, **caractérisé en ce que** les circuits de charge comprennent un transistor cascode et un transistor suiveur, à l'exception des circuits de charge de rang N+3 et de rang 0 qui ne comportent qu'un transistor de cascode mais pas de transistor suiveur.

## Claims

1. An analog-digital converter with signal folding circuits, comprising at least two folding blocks, each block comprising a series of N+1 differential circuits (CRⱼ) of rank 1 to N+1, with N integer, and a series of N+2 load circuits (CHⱼ) of rank 1 to N+2 connected to the differential circuits of the series of differential circuits, the differential circuits of each block being juxtaposed and linked to one another by their outputs (S2ⱼ, S1ⱼ₊₁), each differential circuit having four inputs and two outputs, the first output (S1ⱼ) of a differential circuit of rank j being linked to the second output of a preceding differential circuit of rank j-1 of the series and the second output (S2ⱼ) of the differential circuit considered being linked to the first output of the following differential circuit of rank j+1, a first load circuit (CHⱼ) of rank j being linked to the first output of the differential circuit (CRⱼ) considered of rank j, this load circuit being shared with the preceding differential circuit of rank j-1 of the series, and a second load circuit of rank j+1 being linked to the second output of the differential circuit concerned of rank j, this load circuit being shared with the following differential circuit of rank j+1 of the series, the load circuits of even rank having an output connected to a first common output (An) of the series and the load circuits of odd rank having an output connected to a second common output (Ap) of the series, **characterized in that** there are provided for all the blocks an additional differential circuit (CR₆) of rank N+2 and an additional load circuit (CH₇) of rank N+3 connected to the second output of the additional differential circuit, the output of the latter load circuit not being linked to a common output of the series, and **in that** there is furthermore provided, in the first folding block, a differential circuit (CR₀) of rank 0 and a load circuit (CH₀) of rank 0 connected to the first output of the differential circuit of rank 0, the output of the load circuit of rank 0 not being linked to a common output of the first block.

2. The converter as claimed in claim 1, **characterized in that** the differential circuits consist of a double differential pair of transistors, a transistor of one pair having its collector linked to the collector of a transistor of the other pair and vice versa.

3. The converter as claimed in one of claims 1 and 2, **characterized in that** the load circuits comprise a cascode transistor and a follower transistor, with the exception of the load circuits of rank N+3 and of rank 0 which comprise only a cascode transistor but no follower transistor.

## Patentansprüche

1. Analog-Digital-Wandler mit Signalfaltungsschaltungen, der wenigstens zwei Faltungsblöcke, wobei jeder Block eine Serie von N+1 Differentialschaltungen (CRⱼ) mit Rang 1 bis N+1, wobei N eine ganze Zahl ist, und eine Serie von N+2 Ladeschaltungen (CHⱼ) mit Rang 1 bis N+2 umfasst, die mit den Differentialschaltungen der Differentialschaltungsserie verbunden sind, wobei die Differentialschaltungen jedes Blocks nebeneinander liegen und an ihren Ausgängen (S2ⱼ, S1ⱼ₊₁) miteinander verbunden sind, wobei jede Differentialschaltung vier Eingänge und zwei Ausgänge hat, wobei der erste Ausgang (S1ⱼ) einer Differentialschaltung mit Rang j mit dem zweiten Ausgang einer vorhergehenden Differentialschaltung mit Rang j-1 der Serie verbunden ist und der zweite Ausgang (S2ⱼ) der betrachteten Differentialschaltung mit dem ersten Ausgang der nachfolgenden Differentialschaltung mit Rang j+1 verbunden ist, wobei eine erste Ladeschaltung (CHⱼ) mit Rang j mit dem ersten Ausgang der betrachteten Differentialschaltung (CRⱼ) mit Rang j verbunden ist, wobei diese Ladeschaltung mit der vorhergehenden Differentialschaltung mit Rang j-1 der Serie gemeinsam genutzt wird, und wobei eine zweite Ladeschaltung mit Rang j+1 mit dem zweiten Ausgang der betrachteten Differentialschaltung mit Rang j verbunden ist, wobei diese Ladeschaltung mit der nachfolgenden Differentialschaltung mit Rang j+1 der Serie gemeinsam genutzt wird, wobei die Ladeschaltungen mit geradzahligem Rang einen Ausgang haben, der mit einem ersten gemeinsamen Ausgang (An) der Serie verbunden ist, und die Ladeschaltungen mit ungeradzahligem Rang einen Ausgang haben, der mit einem zweiten gemeinsamen Ausgang (Ap) der Serie verbunden ist, **dadurch gekennzeichnet, dass** für alle Blöcke eine zusätzliche Differentialschaltung (CR₆) mit Rang N+2 und eine mit dem zweiten Ausgang der zusätzlichen Differentialschaltung verbundene zusätzliche Ladeschaltung (CH₇) mit Rang N+3 vorgesehen ist, wobei der Ausgang dieser letzteren Ladeschaltung nicht mit einem gemeinsamen Ausgang der Serie verbunden ist, und dadurch, dass darüber hinaus im letzten Faltungsblock eine Differentialschaltung (CR₀) mit Rang 0 und eine mit dem ersten Ausgang der Differentialschaltung mit Rang 0 verbundene Ladeschaltung (CH₀) mit Rang 0 vorgesehen ist, wobei der Ausgang der Ladeschaltung mit Rang 0 nicht mit einem gemeinsamen Ausgang des ersten Blocks verbunden ist.

2. Wandler nach Anspruch 1, **dadurch gekennzeichnet, dass** die Differentialschaltungen von einem Differentialdoppelpaar von Transistoren gebildet werden, wobei der Kollektor eines Transistors von einem Paar mit dem Kollektor eines Transistors des anderes Paars verbunden ist und umgekehrt.

3. Wandler nach einem der Ansprüche 1 und 2, **dadurch gekennzeichnet, dass** die Ladeschaltungen einen Kaskodentransistor und einen Folgetransistor umfassen, mit Ausnahme der Ladeschaltungen mit Rang N+3 und Rang 0, die nur einen Kaskodentransistor, aber keinen Folgetransistor umfassen.
